# NEUE EUROPÄISCHE PATENTSCHRIFT

(11) **EP 0 656 025 B2**
(45) Veröffentlichungstag und Bekanntmachung des Hinweises auf die Entscheidung über den Einspruch: **27.09.2000**
(45) Hinweis auf die Patenterteilung: 08.10.1997
(21) Anmeldenummer: 93918920.5
(22) Anmeldetag: 20.08.1993
(51) Int. Cl.: C08G 61/12, C08G 73/02, C25D 5/54, H05K 3/42

(54) **LÖSUNG ZUR BESCHICHTUNG VON NICHTLEITERN MIT LEITFÄHIGEN POLYMEREN UND VERFAHREN ZU DEREN METALLISIERUNG**
SOLUTION FOR COATING NON CONDUCTORS WITH CONDUCTIVE POLYMERS AND THEIR METALLIZATION PROCESS
SOLUTION D'ENDUCTION DE NON-CONDUCTEURS AVEC DES POLYMERES CONDUCTEURS ET LEUR PROCEDE DE METALLISATION

(30) Priorität: 20.08.1992 DE 4227836
(43) Veröffentlichungstag der Anmeldung: 07.06.1995
(73) Patentinhaber: ATOTECH Deutschland GmbH, 10553 Berlin (DE)
(72) Erfinder: RAGGE, Andrea, D-10589 Berlin (DE); MEYER, Heinrich, D-14109 Berlin (DE); URRUTIA DESMAISON, Gonzalo, D-10587 Berlin (DE)
(74) Vertreter: Effert, Udo, Dipl.-Ing.
(86) Internationale Anmeldenummer: DE9300780
(87) Internationale Veröffentlichungsnummer: WO9404591

(56) Entgegenhaltungen:
- EP-A- 0 129 070
- EP-A- 0 241 728
- EP-A- 0 432 929
- EP-A- 0 457 180
- EP-A- 0 553 671
- WO-A-91/08324
- US-A- 4 959 162
- DATABASE WPI Week 9044, Derwent Publications Ltd., London, GB; AN 90-332402 & JP,A,2 240 139 (FUJI PHOTO FILM KK) 25. September 1990

## Beschreibung

Die Erfindung betrifft eine Lösung sowie ein Verfahren zur Metallisierung von Nichtleitern unter Verwendung von leitfähigen Polymeren.

Es ist bekannt, Nichtleiteroberflächen schrittweise folgendermaßen zu bearbeiten:
a) Behandeln mit einer suspendiert oder gelöste Oxidationsmittel enthaltenden Lösung, so daß an der Nichtleiteroberfläche ein Oxidationsmittel adsorbiert wird oder entsteht,
b) Behandeln mit einer Lösung, die mindestens eine aromatische Verbindung, die durch Oxidation in ein leitfähiges Polymer überführt werden kann, und mindestens ein wasserlösliches Polymer enthält,
c) Galvanisch metallisieren.

In den Druckschriften DE 38 06 884 C1 und EP 0 413 109 A2 werden derartige Verfahren unter Anwendung von leitfähigen Polymeren zur Metallisierung von Nichtleitern beschrieben. Entscheidend bei beiden Verfahren ist, daß der sonst notwendige Zwischenschritt der chemischen Metallisierung ausgelassen werden kann und die galvanische Metallisierung in einem kürzeren Prozeß erreicht wird.

Die vorbeschriebenen Verfahren weisen jedoch technische Nachteile auf. Gemäß der DE 38 06 884 C1 wird das zur Herstellung des leitfähigen Polymers benötigte Monomer auf Braunstein adsorbiert und die für die Polymerisation notwendige Säure erst anschließend zugegeben. Dieser Ablauf hat zur Folge, daß die Monomermenge sowohl durch dessen Adsorptionskapazität auf Braunstein als auch durch die Menge an Braunstein auf der Nichtleiteroberfläche begrenzt wird. Hierdurch kann entweder eine nicht ausreichende Polymerisation durch Oxidation des Monomeren oder eine Überoxidation eintreten, so daß die notwendige Verfahrenssicherheit nicht gewährleistet ist.

Der Nachbehandlungsschritt des in der DE 38 06 884 C1 beschriebenen Verfahrens mit Säure stellt den essentiellen Schritt zur Polymerisation des Monomeren zum leitfähigen Polymer dar, denn zur chemischen Darstellung eines leitfähigen Polymers ist neben dem Oxidationsmittel eine Säure erforderlich. Diese Schrittfolge bewirkt eine Verfahrensverlangerung. Ferner werden bei diesem Verfahren flüchtige Lösungsmittel gemeinsam mit dem flüchtigen Pyrrol verwendet und dadurch die Umwelt belastet sowie die Arbeitssicherheit beeinträchtigt, da zur ausreichenden Polymerisation eine hohe Konzentration des Monomeren in der Lösung verwendet werden muß, so daß Lösungsvermittler beim Einsatz von Wasser als bevorzugtem Lösungsmittel zu der Lösung zugegeben werden müssen.

Im Verfahren gemäß der EP 0 413 109 A2 wird dagegen bereits fertiges Polyanilin verwendet und durch Beschichtung auf die Nichtleiteroberfläche appliziert. Neben der erforderlichen Voraussynthese des Polyanilins stellen die Selektivität des Verfahrens und die nicht immer ausreichende Haftung der Polymerschicht auf der Nichtleiteroberfläche wesentliche Probleme dieses Verfahrens dar.

In den Druckschriften DE 39 39 676 A1 und EP 0 457 180 A2 wird ein Verfahren zur Metallisierung beschrieben, das auf den Verfahrensschritten
- Vorquellen in organischen Lösungsmitteln,
- Beizen mit Permanganat,
- Pyrrolpolymerisation in Säure und
- Metallisierung

beruht. Dieses Verfahren nutzt das oxidative Spektrum des Permanganats nicht, um genügend Oxidationsmittel (Braunstein) zu erzeugen, und es ist ein zusätzlicher Vorbehandlungsschritt mit organischen Lösungsmitteln erforderlich. Der Einsatz des für den Quellschritt verwendeten N-Methylpyrrolidons ist wegen der begrenzten Standzeit des Quellbades ungünstig, da die Verbindung nur eine geringe Säurestabilität aufweist. Die in den beiden Druckschriften angegebenen Temperaturen des Pyrrolpolymerisatonsbades stellen kein Optimum für eine gleichmäßige Leitschicht dar. Außerdem stellt auch bei diesen Verfahren die Flüchtigkeit der verwendeten Lösungsmittel und des Pyrrols ein Problem dar, da durch deren Emission aus den Behandlungsanlagen die Umwelt belastet und die Arbeitssicherheit beeinträchtigt wird.

In der US-PS 4,617,228 wird ein Verfahren zur Imprägnierung von porösen Trägermaterialien, beispielsweise von Glasfaservlies, beschrieben, indem eine flüssige Pyrrolverbindung und eine Lösung eines starken Oxidationsmittels nacheinander mit dem Trägermaterial in Gegenwart eines nicht-nukleophilen Anions in Kontakt gebracht werden. Die Leitfähigkeit des Trägermaterials wird durch die niedergeschlagene Leitschicht aus leitfähigem Polymer erreicht. Eine weitere galvanische Metallisierung der leitfähigen Polymerschicht oder elektrische Widerstandswerte der leitfähigen Polymerschicht sind nicht offenbart, so daß nicht erkennbar ist, ob eine ausreichende Galvanisierfähigkeit überhaupt gegeben sind.

In der Druckschrift JP 63 125696 A wird die Plattierung von Nichtleitern unter Verwendung eines chemisch hergestellten Polypyrrolfilmes und anschließender Galvanisierung beschrieben. Der dort angegebene Polyvinylalkohol stellt ein Imprägnierungsmittel dar und wird als Solvens in der Funktion einer Matrix für den organischen Leiter zugegeben. Die Polymerisation erfolgt dabei in der kondensierten Matrix des Imprägnierungsmittels Polyvinylalkohol. Es wird nicht die in-situ-Darstellung des Oxidationsmittels, das - wie Braunstein - fest auf der Nichtleiteroberfläche haftet, beschrieben. Als Beispiel wird die Reaktion von Eisen-III-chlorid in einer vorerzeugten Matrix mit Pyrrol angegeben. Ein Hinweis zur Lösung des Problems der Flüchtigkeit der zu einem leitfähigen Polymer oxidierbaren aromatischen Verbindung ist ebenfalls nicht enthalten.

Bei der industriellen Anwendung dieser Lösungen hat sich gezeigt, daß die genannten aromatischen Verbindungen, wie beispielsweise Pyrrol, einen relativ hohen Dampfdruck aufweisen, so daß sich bei längerem Betrieb in der Umgebung der diese Lösungen enthaltenden Behälter schwarze Niederschläge an beliebigen Oberflächen bilden, die durch kleinste Spuren von Säuren, dem Luftsauerstoff und der gasförmig hinzutretenden Verbindung entstehen.

Um die Emission der aromatischen Verbindungen zu unterbinden, ist der Betrieb derartiger Behandlungslösungen gemäß dem Stand der Technik in geschlossenen Anlagen bekannt. Dies ist jedoch aufwendig und kostspielig und überdies wirtschaftlich vertretbar nur für bestimmte ansonsten vorteilhafte Behandlungstechniken einsetzbar, beispielsweise bei der horizontalen Führung von Leiterplatten bei deren Durchkontaktierung.

Ausgehend vom Stand der Technik liegt daher der Erfindung das Problem zugrunde, eine Lösung zu entwickeln, mit der in einem geeigneten Verfahren elektrisch gut leitfähige Polymerschichten für eine anschließende Metallisierung von technisch relevanten nichtleitenden Trägermaterialien erzeugt werden können und insbesondere die Durchkontaktierung von Leiterplatten zuverlässig möglich ist, unter Vermeidung einer starken Emission aromatischer Verbindungen.

Das Verfahren soll auch für die Flächenmetallisierung geeignet sein und eine gleichmäßige und vollständige Metallisierung mit hoher Selektivität erzielen. Hierunter ist die Anforderung zu verstehen, daß das leitfähige Polymer nur auf den nichtleitenden Oberflächen des Nichtleiters abgeschieden werden soll, nicht dagegen auf den leitfähigen Flächen, wie beispielsweise den Kupferflächen auf Leiterplatten.

Die Probleme werden durch die Merkmale der Ansprüche 1 und 15 gelöst. Weiterbildungen der Erfindung sind in den Unteransprüchen erfaßt.

Die erfindungsgemäße Lösung enthält neben den zur Herstellung der leitfähigen Polymeren benötigten aromatischen Verbindungen wasserlösliche Polymere, die Homopolymere und/oder Copolymere sind Ausgenommen ist eine Verwendung von Lösungen, die in EP 0 553 671 A1 beschrieben sind, zur Bildung leitfähiger Polymerer auf Nichtleiteroberflächen, insbesondere zur Metallisierung von Nichtleitern. Diese Lösungen enthalten ein Thiophen der allgemeinen Formel 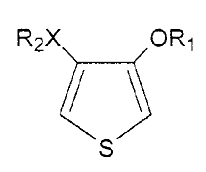 in der X für Sauerstoff oder eine einfache Bindung, R₁ und R₂ unabhängig voneinander für Wasserstoff oder eine C₁-C₄-Alkylgruppe stehen oder zusammen einen substituierten oder unsubstituierten C₁-C₄-Alkylenrest oder einen Cyclohexylen-1,2-Rest bilden, und ein wasserlösliches Polymer, ausgewählt aus der Gruppe, bestehend aus polymeren organischen Säuren und Copolymeren dieser Säuren mit anderen säuregruppenfreien Monomeren. Unter den Copolymeren werden im Rahmen der Erfindung Blockpolymere verstanden, die größere Molekülbereiche mit identischen Repetiereinheiten enthalten. Außerhalb des Bereichs der Erfindung liegen Biopolymere wie Gelatine und anionische Polyelektrolyte. Das wasserlösliche Polymer hat die Aufgabe, den Dampfdruck der aromatischen Verbindung abzusenken. Wäßrige Lösungen, beispielsweise von Pyrrol, erleiden eine stetige Verarmung an Monomer durch Verdampfungsverluste. Gibt man wasserlösliche Polymere in die Monomerlösung, so läßt sich die Emission von Pyrrol reduzieren.

Geignete wasserlösliche Polymere sind Verbindungen, die vor allem zur Bildung von Wasserstoffbrücken oder zur Bildung ausreichend adsorptiver und van der Waals-Wechselwirkungen befähigt sind. Außerdem können die Verbindungen in wäßrigen Lösungen bevorzugt Protonierungs/Deprotonierungsreaktionen eingehen.

Ohne durch die theoretischen Überlegungen gebunden zu sein, kann vermutet werden, daß die beanspruchte Gruppe der homopolymeren und copolymeren wasserlöslichen Verbindungen besonders gut zur Ausbildung der erforderlichen chemischen Wechselwirkungskräfte mit den relativ starren Ketten der leitfähigen Polymeren und deren Vorläufern, den monomeren und oligomeren aromatischen Verbindungen, befähigt sind, da sie große Bereiche gleicher Strukturelemente mit wiederkehrenden Repetiereinheiten enthalten. Liegen innerhalb dieser monoton aufgebauten Strukturregionen die für die Ausbildung der erwähnten chemischen Wechselwirkungen erforderlichen funktionellen Gruppen, wie beispielsweise Ethergruppierungen, so kann eine Verringerung des Dampfdruckes der aromatischen Verbindung in der sauren Lösung und eine ausreichend hohe Leitfähigkeit der leitfähigen Polymerschicht erreicht werden.

Bei Biopolymeren, wie beispielsweise Gelatine, die eine Polyaminosäure aus vielen verschiedenen Strukturelementen ist, wobei die einzelnen Aminosäureeinheiten innerhalb des Gelatinemoleküls statistisch verteilt sind, ist die Ausbildung der notwendigen starken chemischen Wechselwirkungskräfte nur ungenügend möglich, da eine Aneinanderlagerung der leitfähigen Polymerketten mit diesen polymeren Verbindungen wegen der Inkompatibilität der räumlichen Strukturen der leitfähigen Polymerketten und dieser Verbindungen nicht erfolgen kann. Durch Zusatz dieser Verbindungen werden daher leitfähige Polymerschichten mit geringerer elektrischer Leitfähigkeit erzeugt.

Besonders geeignet sind daher solche wasserlöslichen Polymere, die ausschließlich oder überwiegend ungeladene Strukturelemente im Polymergerüst aufweisen oder kationische Polyelektrolyte sind. Hierzu gehören Verbindungen, die eine oder mehrere Hydroxyl-, Amid-, Sulfonamid-, Amin-, Keto-Enol-, Ether-, Keto-, Sulfoxid-Gruppen, quaternäre Ammonium-und/oder Hetariniumgruppen im Molekül enthalten. Unter Hetariniumgruppen sind im Rahmen der vorliegenden Erfindung Stickstoff enthaltende Heteroaromaten mit positiver Ladung am Stickstoff zu verstehen, wie beispielsweise Imidazolium- oder Benzimidazoliumverbindungen.

Es hat sich herausgestellt, daß Verbindungen der Gruppen Polyalkylenoxide, Polyalkylenimine, Polyvinylpyridine, Polyvinylpyrrolidone, Polyacrylamid, Polyvinylalkohol sowie aus Epihalohydrin und Imidazolen oder Benzimidazolen hergestellte Polymere, aus mit quaternären Ammoniumgruppen derivatisierten Acrylsäure-oder Methacrylsäureverbindungen hergestellte Polymere, Poly (diallyldimethylammoniumhalogenid), quaternisierte Polypiperidiniumverbindungen, Polyaminsulfone, quaternisierte Polyvinylimidazoliumsalze, quaternisierte Polyvinylpyridiniumsalze, lonene und deren Derivate besonders vorteilhaft einsetzbar sind. Unter den genannten Halogeniden sind insbesondere die Chloride, Bromide und lodide zu verstehen.

] Typische Vertreter von wasserlöslichen Polymeren, die zur Lösung der Aufgabe beispielsweise eingesetzt werden können, sind:
Polyethylenimin,
Poly(N-methyl-ethylenimin),
Polyvinylalkohol,
Polyethylenoxid,
Polypropylenoxid,
Copolymerisat aus Polyethylenoxid und
Polypropylenoxid,
Polyacrylamid,
Poly-1-vinylpyrrolidon,
Poly(2-vinylpyridin) ,
Poly(4-vinylpyridin),
Polyethylenglykol,
Poly(N-methyl-N-vinylimidazoliummethosulfat), Polyaminsulfone,
Poly(N,N-dimethyl-3,5-dimethylenpiperidiniumchlo- rid),
Poly«3-chlor-2-hydroxypropyl)-1-imidazol) und
Poly(N, N-diallyldimethylammoniumchlorid).

Eine Zusammenstellung der verwendbaren wasserlöslichen Polymere findet man in "Water-Soluble Polymers" von Y.L Meltzer, Noyes Data Corporation (1972). Hierzu gehören zusätzlich zu den oben genannten Verbindungen und Verbindungsklassen u.a. die folgenden Verbindungen: Polyepihalohydrin als Hydroxyl-, Amin- oder heterocyclisches Derivat und Polyacrylamid oder deren am Stickstoff substituierte Alkyl-, Alkylamin- , Alkyloxy- oder Alkylcarboxy-Derivate. Viele dieser Polymere können im Handel erworben werden.

Die Konzentration der wasserlöslichen Polymere in der sauren Lösung soll einen Wert von 2 g/I nicht unterschreiten, um die beschriebenen Wirkungen des Zusatzes zu erreichen. Als vorteilhaft hat sich ein Konzentrationsbereich zwischen 2 g/I und 250 g/i herausgestellt. Zu hohe Konzentrationen führen zu einem durch Verschleppung der Lösung verursachten zu hohen Verbrauch der wasserlöslichen Polymeren. Das würde zu hohe Rohstoffkosten und zusätzliche Aufwendungen bei der Abwasseraufbereitung zur Folge haben.

Die Temperatur der sauren Lösung wird vorzugsweise zwischen dem Gefrierpunkt der Lösung, etwa -10 °C, und etwa +30 °C eingestellt. Die obere Temperaturgrenze ergibt sich daraus, daß die Stabilität der Lösung bei zu hohen Temperaturen deutlich absinkt, da es in diesem Fall zu Selbstzersetzungen der aromatischen Verbindungen kommt.

Der pH-Wert der sauren Lösung liegt vorzugsweise zwischen pH 0 und pH 4. Stärker saure Lösungen führen ebenso wie zu hohe Temperaturen zu instabilen Lösungen. Eine Lösung mit einem pH-Wert über 4 vermag kein leitfähiges Polymer in ausreichender Geschwindigkeit abzuscheiden.

Das zur Metallisierung von Nichtleiteroberflächen bevorzugt eingesetzte Verfahren, bei dem die erfindungsgemäße Lösung verwendet wird, besteht aus folgenden Schritten:
1. Die Nichtleiter-Oberfläche wird mit dem Ziel, Oxidationsmittel auf der Nichtleiteroberfläche zu erzeugen oder zu adsorbieren, vorbehandelt.
2. Das vorbehandelte Trägermaterial wird mit der erfindungsgemäßen Lösung behandelt, die die wasserlöslichen Polymere und die aromatischen Verbindungen, die durch Oxidation mit dem in Schritt 1. gebildeten Oxidationsmittel auf der Nichtleiteroberfläche zu einem intrinsisch leitfähigen Polymer polymerisiert werden, enthält. Dabei wird eine leitfähige Schicht gebildet.
3. Die zuvor isolierenden und nunmehr leitenden Flächen werden in einem galvanischen Bad metallisiert.

Als Trägermaterialien (Nichtleiter) kommen Kunststoffe und glasfaserverstärkte Harze oder Polymere, die einer Vorbehandlung durch Quellen und Ätzen zugänglich sind, in Frage. Hierzu gehören Polycarbonate, Acrylnitril-Butadien-Styrol-Copolymere (ABS), Cyanatester, Phenolharz (FR2), Epoxid-Hartpapier (FR3) und insbesondere glasfaserverstärktes Epoxidharz (FR4). In Klammern sind die gebräuchlichen Typenbezeichnungen des Handels angegeben.

In einer bevorzugten Ausführungsform wird das Trägermaterial, bevorzugt glasfaserverstärktes Epoxidharz, mit Kaliumpermanganat oxidativ in alkalischer Lösung behandelt. Dieser allgemein übliche Schritt in der Leiterplattenherstellung zur Oberflächenreinigung hat im erfindungsgemäßen Verfahren die erweiterte Funktion, gleichermaßen das für die Oxopolymerisation der aromatischen Verbindung zu intrinsisch leitfähigen Polymeren notwendige Oxidationsmittel, den Braunstein (Mangan-IV- und/oder - III-Oxid, Mangandioxid/hydroxid) zu erzeugen. Diese Funktionen werden ebenso von Manganaten wie beispielsweise Natriummanganat erfüllt, indem sie eine wirksame Spezies bei Oxidationen mit Permanganat sind und andererseits ebenso Braunstein in alkalischer Lösung bilden. Die Manganatstufe ist bei den in der Praxis üblichen Temperaturen und längeren Betriebszeiten sicher eine wirksame Spezies, da Kaliummanganat aus Kaliumpermanganat und Kaliumhydroxid bei 100°C darstellbar ist.

Die Oxidationslösung sollte über gleichmäßige und genügende Aktivität verfügen. In der Praxis ist jedoch mit schwankender Konzentration zu rechnen. Die Oxidationslösungen werden besser kontrollierbar und bedürfen keiner Einarbeitungszeit, wenn man in Weiterbildung der Erfindung hohe Konzentrationen an Permanganat und Alkali einstellt und das verbrauchte Manganat durch Kochen nachbildet. Ergebnis der oxidativen Reinigung ist in jedem Falle die stabile Zwischenstufe Braunstein. Es kommt besonders darauf an, den am Reaktionsort entstandenen Braunstein in ausreichender Menge als Reaktionsprodukt zu erhalten.

Es ist vorteilhaft, den in der Lösung sich zunehmend anreichernden mikrokristallinen Braunstein am Reaktionsort zu co-adsobieren. Auch die Braunsteinmenge kann bei Bedarf erhöht werden, indem Mangansulfat hinzugefügt wird.

Eine alternative Aufbringung von Oxidationsmittel läßt sich erfindungsgemäß erzielen, indem das Trägermaterial mit einer Lösung aus Eisen-III-chlorid, beispielsweise in Propylencarbonat, Wasser, Ethylenglykol, N-Methylpyrrolidon oder anderen polaren Lösungsmitteln in Kontakt gebracht, beispielsweise getaucht, wird.

Als aromatische Verbindungen, die als monomere Vorstufen für die leitfähigen Polymere im Sinne der Erfindung verwendet werden, kommen vor allem Pyrrol, Anilin und Thiophen sowie Dimere und Derivate dieser Monomere in Frage. Die Chemie der leitfähigen Polymere wird ausführlich von Skotheim im "Handbook of Conducting Polymers", Dekker, 1986 beschrieben. Allerdings entnimmt man der Literatur nicht, welchen Reaktionsmechanismus die chemische Polymerisation hat. Die Erfinder stellten fest, daß die Menge an gebildetem leitfähigem Polymer durch die Menge an Braunstein oder Eisen-III-chlorid vorgegeben wird.

Nachdem im ersten Prozeßschritt in gewünschter Menge Braunstein in-situ erzeugt oder Eisen-III-chlorid auf der Nichtleiteroberfläche adsorbiert wurde, wird diese in der vorliegenden Erfindung mit einer monomerhaltigen Säurelösung eines wasserlöslichen Polymers behandelt.

Dabei reagiert das aus der Lösung angebotene Monomer an der Braunsteinoberfläche des vorbehandelten Nichtleiters und oxopolymerisiert zu intrinsisch leitfähigem Polymer.

Das in der Lösung enthaltene wasserlösliche Polymer geht mit der aromatischen Vorstufe des leitfähigen Polymers chemische Wechselwirkungen in der Lösung ein und adsorbiert gleichzeitig mit der aromatischen Verbindung an der Oberfläche der mit dem Oxidationsmittel belegten Nichtleiteroberfläche.

Indem der entstandene Braunstein sofort zur Reaktion mit der Säurelösung des Monomeren und des wasserlöslichen Polymeren zur Verfügung steht, wird der Nachteil der nicht ausreichend sicheren Verfahrensweise gemäß dem Stand der Technik umgangen. Es kann nur soviel Polymer entstehen, wie Oxidationsmittel vorhanden ist und es kann in dem Maße Oxidationsmittel erzeugt werden, wie es die gewünschte Menge an Polymer bzw. die Leitfähigkeit erfordert. Die Gefahr einer Überoxidation besteht nicht. Es können auch keine Oxidationsmittelrückstände im Substrat zurückbleiben, da die Oxide verbraucht werden und in lösliche Verbindungen in niederen Oxidationsstufen übergehen.

Es stellte sich überraschend heraus, daß durch Zusatz der erfindungsgemäßen wasserlöslichen Polymere auch viele unterschiedliche Materialien nebeneinander beschichtet und anschließend dicht metallisiert werden können, ohne daß die Verfahrensbedingungen verändert zu werden brauchen. Das ist beispielsweise bei der Durchkontaktierung von Leiterplatten erforderlich, da in diesem Fall zum einen die Polymeroberfläche des Leiterplattenmaterials und zum anderen die in die Bohrung hineinragenden Glasfaserenden gleich gut beschichtet werden müssen.

Einerseits bildet sich auf Glas kaum Braunstein, auch wird es nicht nennenswert adsorbiert und andererseits vermögen die starren Ketten des leitfähigen Polymers nur zufällig die notwendige Kontaktwechselwirkung für die Physisorption beizusteuern. Wasserlösliche Polymere verfügen dagegen über ein bewegliches Polymergerüst und lassen sich mit den gewünschten adsorptiven Eigenschaften ausstatten, so daß die Eigenschaft als Zusatzstoff zur Verbesserung der Glasfaserbedeckung gezielt eingestellt werden kann.

Die Wirksamkeit wasserlöslicher Polymerer zur gleichmäßigen Bedeckung sowohl der Polymeroberflächen in den Leiterplattenbohrungen als auch der Glasfaserenden wird mit dem in "Handbuch der Leiterplattentechnik", Band 3, S. 72/73, herausgegeben von Günther Herrmann, Eugen G. Leuze Verlag, Saulgau 1993, beschriebenen und Durchlichttest gemessen. Hierzu wird die Bohrung nach erfolgter Metallisierung nach der Polymerbeschichtung längs aufgeschnitten und die Lichtdurchlässigkeit der Metallschicht vermittels einer starken Beleuchtungsquelle, die die Halbfläche der Bohrlochwand von unten durchleuchtet, mit einem Mikroskop ermittelt.

Weiterhin beeinträchtigen die für die Metallisierung verwendeten erfindungsgemäßen wasserlöslichen Polymere die Leitfähigkeit der erzeugten Polymerschicht nicht. Dies ist sehr wichtig, um die Metallisierbarkeit der Schicht auch in kurzer Zeitspanne zu gewährleisten. Mit dem Stand der Technik kann weder das Problem des hohen Dampfdruckes der aromatischen Verbindung zufriedenstellend gelöst noch gleichzeitig die ausreichend dichte Metallisierung von Glasfasern nach der Beschichtung mit dem leitfähigen Polymer und eine ausreichend gute Leitfähigkeit der Polymerschicht gewährleistet werden. In den Druckschriften EP 0 457 180 A2 und US-PS 4,617,228 ist zwar angegeben, daß die dort beschriebenen Zusatzstoffe, wie beispielsweise Gelatine oder Polyvinylsulfonat, die Metallisierbarkeit der Glasfasern verbessern. Jedoch haben Versuche ergeben, daß in diesem Fall die elektrische Leitfähigkeit der erzeugten Schichten geringer ist als ohne Zusatz. Darüber hinaus wird der Dampfdruck der aromatischen Verbindung durch Zusatz dieser Stoffe nicht wie gewünscht abgesenkt.

Ein weiterer Vorteil bei der Verwendung des wasserlöslichen Polymer-Zusatzes ist die verbesserte Duktilität der leitfähigen Polymerschicht durch Einbau des wasserlöslichen Polymers in diese Schicht. Beschichtungen aus leitfähigem Polymer sind ohne besondere Maßnahmen brüchig. Insbesondere kann die thermische Belastung oder der Massenaustausch von Ionen und Wasser Mikrorisse zur Folge haben. Die Wahrscheinlichkeit solcher Defekte wächst mit der Schichtdicke und wird größer mit der elektrostatischen und mechanischen Belastung der starren Polymerketten.

Nach der Beschichtung des Nichtleiters mit dem leitfähigen Polymer wird die gebildete Schicht galvanisch metallisiert. Die galvanische Metallabscheidung wird mit handelsüblichen galvanischen Bädern durchgeführt. Unter der Maßgabe, daß die organischen Leiter nicht zu hohe reduktive Anfangspotentiale erleiden, können prinzipiell alle Metalle abgeschieden werden. Es werden säurehaltige Bäder mit pH 0 bis 4, zur Abscheidung von Kupfer insbesondere schwefelsaure Kupferbäder mit 10 bis 300 g/I freier Schwefelsäure und einem Kupfergehalt von 5 bis 50 g/l bevorzugt.

Die Galvanisierung wird unter den üblichen Strom- und Temperaturbedingungen durchgeführt, beispielsweise mit einer Stromdichte von 0,1 bis 20 A/dm² bei einer Temperatur von 20 bis 70 °C.

Die galvanische Abscheidung kann direkt nach der Erzeugung der Leitschicht auch ohne Spülschritt durchgeführt werden. Es ist aber auch möglich, vor der Metallisierung Wartezeiten oder längere Trokkenverweilzeiten bei Raumtemperatur ohne Verlust der Metallisierbarkeit einzulegen. Je nach geometrischen Anforderungen beziehungsweise der Entfernung zwischen der Kontaktierungsstelle zur Stelle, an der die Metallisierung stattfindet, können in besonders günstigen Fällen gleichmäßig geschlossene flächige Metallisierungen binnen 2 min erzielt werden.

Das Verfahren wird üblicherweise in vertikalen Tauchanlagen durchgeführt. Jedoch kann das Verfahren auch in einer horizontalen Behandlungsanlage betrieben werden, beispielsweise für die Herstellung von Leiterplatten.

Die Behandlungslösungen können mit dem zu behandelnden Trägermaterial alternativ durch Tauchen, Schwallen, Sprühen oder Spritzen in Kontakt gebracht werden.

Neben der Anwendung bei der Durchkontaktierung oder Flächenmetallisierung von Leiterplatten ist die flächige Metallisierung von Materialien mittels des erfindungsgemäßen Verfahrens auch für dekorative Zwecke, wie beispielsweise in der Sanitärtechnik oder in der Beschlägeindustrie oder für funktionelle Anwendungen wie der Herstellung von gegen elektromagnetische Strahlung abgeschirmten Computergehäusen oder anderen Gehäusen von elektrischen Geräten, geeignet.

Die folgenden Beispiele sollen die Erfindung näher erläutern:

### Beispiel 1 (Referenz)

Zur Prüfung der dynamischen Verdampfung der aromatischen Verbindung wurde eine Lösung aus 7,7 g/l Pyrrol in 1 M Phosphorsäure in einer Schale bei 5 ⁺/- 1 °C in einem Digestorium mit einer Abluftleistung von 640 m³/h für eine Stunde der Verdampfung ausgesetzt. Die Pyrrolkonzentration in der Lösung nahm dabei ab. Die Verluste wurden mittels der UV-Absorption bei 208 nm in wäßrigem Medium verfolgt, der Verlustkoeffizient betrug-3,4 · 10⁻⁶ g/l/min/cm².

Eine Lösung mit 100 g/l Polyvinylpyrrolidon K15 (Bezugsquelle: Firma Aldrich, Deutschland) führte bei gleichen Versuchsbedingungen zu einer deutlich geringeren Verdampfungsrate mit einem Koeffizienten von -1,6 · 10-6 g/l/min/cm².

Mit 100 g/l Polyethylenglykol erzielte man - 2,5 · 10⁻⁶ g/l/min/cm².

Bei höherer Luftströmung betrug der Koeeffizient einer zusatzfreien Lösung -8,5 . 10-⁶ g/l/min/cm², mit 203 g/l Polyethylenglykol 200 betrug er dagegen nur -3,3 · 10-6 g/l/min/cm².

In den folgenden Beispielen wurden nach der Metallisierung der Proben Leitfähigkeitsmessungen durchgeführt, die an Goldkontakten im Abstand von 1 cm mit einem Auflagengewicht von 1,7 kg mit einem FLUKE 25 Multimeter der Firma Fluke, Deutschland erfolgten.

### Beispiel 2: (Vergleich)

Eine zugeschnittene halbseitig kaschierte Leiterplatte aus glasfaserverstärktem Epoxid wurde wie folgt metallisiert:
1. Oxidative Vorbehandlung in einer wäßrigen Lösung mit 80 g/l (möglicher Bereich 20-130 g/l) Kaliumpermanganat und 20 g/l (möglicher Bereich 10 - 70 g/I) Kalium-oder Natriumhydroxid bei 80 °C (möglicher Bereich 40 - 100°C), für vorzugsweise 1 min (möglicher Bereich 0,1 - 20 min).
2. Spülen
3. Bildung der Leitschicht in einer Lösung von 20 g/l (möglicher Bereich 0,1 g/l - 200 g/l) Pyrrol in 1 M Phosphorsäure oder anderen Säuren mit pH 1 (möglicher Bereich pH 0 - 4) bei 5°C (möglicher Bereich 0 -25 °C) in 5 min. Gemessener Widerstandsbeiwert 1,9 106 Ohm.
4. Fakultatives Spülen in verd. Mineralsäure mit pH 0 bis 2. (Besonders zur Wiederherstellung der Leitfähigkeit nach langen Standzeiten der Leitschicht an Luft, wenn der Prozeß zwischen Schritt 2. und 3. unterbrochen wird.)
5. Metallisierung bei 0,1 - 10 A/dm².

### Beispiel 3: (Vergleich)

Es wurde wie im Beispiel 2 verfahren, bei 3 min langer oxidativer Vorbehandlung betrug der Widerstandsbeiwert 36-10³ Ohm. Metallisierung bei 1,2 A/_{dm}2.

### Beispiel 4: (Vergleich)

Es wurde wie in Beispiel 2 verfahren, die Dauer der oxidativen Vorbehandlung betrug 6 min, der gemessene Widerstandsbeiwert 24 · 10³ Ohm. Metallisierung bei 1,2 A/dm².

### Beispiel 5: (Vergleich)

Bei gleichem Vorgehen wie in Beispiel 2, jedoch mit einer durch langen Betrieb aktiveren Oxidationslösung wurde ein Widerstandsbeiwert von 5 · 10³ Ohm erhalten. Metallisierung bei 5,2 A/dm².

### Beispiel 6: (Vergleich)

3-Methylpyrrol wurde nach J. Cornfoth, D. Ming-hui, J. Chem. Soc. Perkin Trans. I, 1459 (1990) ausgehend von 3-Ethoxymethacrolein und Hippursäure über das 4-Methylpyrrol-2-carboxylat durch Decarboxylierung in 5 Stufen in geringer Ausbeute synthetisiert. Siedepunkt 140-143 °C.

Wiederholung der Beispiele 2, 3 und 4 jedoch mit 3-Methylpyrrol als Monomerem führte zu gemessenen Widerstandsbeiwerten von 2 bis 8 106 Ohm. Die Metallisierung erfolgte bei 1,2 A/dm².

### Beispiel 7: (Vergleich)

3,4-Dimethylpyrrol wurde nach D.O. Cheng, T L. Bowman, E. LeGoff, J. Heterocyclic Chem. 13, 1145 (1976), ausgehend von p-Toluolsulfonylmethylisocyanid und Crotonsäureethylester, synthetisiert. Man erhielt die Dimethyl-Verbindung nach Reduktion des intermediären 3-(Ethoxycarbonyl)-4-methylpyrrols auf schnellem Wege jedoch in nur 18% Gesamtausbeute. Das Material hatte einen Schmelzpunkt von 25-28 °C. H-NMR (CDCI₃): 2,04 (s, 6H), 6,50 (d, 2H), 7,33 (s br, 1 H).

Für die Metallisierung wurde wie in Beispiel 2 verfahren, jedoch mit 3,4-Dimethylpyrrol als Monomer. Der Widerstandsbeiwert betrug 1,4 · 10⁶ Ohm. Die Metallisierung erfolgte bei 1,2 A/dm².

### Beispiel 8:

Analoges Vorgehen zu Beispiel 3, jedoch unter Verwendung von 0,1 N Schwefelsäure (pH 1,2) als Lösungsmittel bei einer Temperatur von 0 - 5 °C und mit 13,4 g/l Pyrrol als aromatischer Verbindung. Zusätzlich enthielt die Lösung 11,1 g/l Polyvinylpyrrolidon K 15, Molgewicht 10000, erhältlich von Firma Aldrich. Der gemessene Widerstandsbeiwert der Schicht nach 1 Std. betrug 11 · 10⁶ Ohm. Die Metallisierung erfolgte mit einer Stromdichte von 2 A/dm².

### Beispiel 9:

7,2 g/l Pyrrol wurden bei pH 1 in 1 M Phosphorsäure mit 11,1 g/l einer 42 % monomerfreien wäßrigen Lösung von Poly(N-methyl-N-vinylimidazolium- methosulfat) als schichtaktivem Zusatz verwendet. Die Polymerisation erfolgte bei einer Temperatur von 25 °C und einer Zeitdauer von 5 min. Nach 4 h Liegenlassen an der Luft wurde ein Widerstandsbeiwert von 20 bis 50 · 10³ Ohm erhalten. Die Metallisierung führte innnerhalb von 2,5 min bei einer Stromdichte von 1,9 A/dm² zu einer dichten Bedeckung des Substrates.

### Beispiele 10 - 13:

Analog zu den Beispielen 2 bis 9 wurden sehr gute Ergebnisse mit folgenden wasserlöslichen Polymeren erhalten:
- Polyethylenglykol 200 und 1000 (bezogen von Firma Aldrich),
- Polyvinylpyrrolidon K 15 und K 90 (Firma Aldrich),
Polyaminsulfone PAS A-5R, PAS A-120LR, PAS 92R, PAS 200R (Handelsnamen der Firma Tozai Boeki Kaisha, Japan),
- Poly(N,N-dimethyl-3,5-dimethylenpiperidiniumchlo- rid) (Firma Aldrich).

### Beispiel 14 und 15:

In Anlehnung an die Beispiele 2 - 13 wurden besonders gute Ergebnisse mit einer vorgekochten oxidativen Vorbehandlungslösung aus 80 g/I Kaliumpermanganat und 40 g/I Natronlauge in Wasser bei 90 °C erhalten. Die besondere Beschaffenheit der Lösung war an der blaugrünen Färbung des Spülwassers erkennbar.

Poly((3-chlor-2-hydroxypropyl)-1-imidazol) wurde aus 34,05 g Imidazol und 47,2 g Epichlorhydrin in 30 ml Ethanol bei 10 bis 25 °C nach 24 h durch Kristallisation bei 10 °C aus der Reaktionslösung erhalten. C-NMR (D₂0): 46,5 (CH₂), 53,0 (CH₂), 63,3 (CH₂), 68,9 (CH), 69,2 (CH), 70,7 (CH), 124 (Imidazolium-H), 137,6 (t, Imidazolium-D).

Poly(N,N-diallyldimethylammoniumchlorid) wurde analog zur Deutschen Patentanmeldung DD 141028 aus 150 ml 60 % wäßriger N,N-Diallyldimethylammoniumchlorid-Lösung mit 1,15 g Ammoniumcarbonat unter Zutropfen von 2,69 g Ammoniumperoxodisulfat in 10 ml Wasser bei 50 °C in 3 h bei 60 bis 80 °C synthetisiert. Der Umsatz betrug 98 % laut Vinyl-H-Signalen. Rest-Monomer wurde durch Umfällen aus Aceton entfernt.

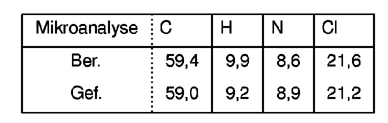

Nach 3 min bei 90 °C in der oxidativen Vorbehandlungslösung und 5 min in einer Lösung aus Pyrrol in 1 M Phosphorsäure mit Poly((3-chlor-2-hydroxypropyl)-1-imidazol) bei 0 bis 5 °C wurde bei 1 A/dm² eine ₄ cm² große Fläche mit einer dicken Kupferschicht in 7 min metallisiert. Ähnliche Ergebnisse wurden mit Poly(N,N-diallyldimethylammoniumchlorid) erhalten.

### Beispiele 16 und 17:

Es wurde wie in Beispiel 9 verfahren. Mit 12 g/l 3,4-Dimethylpyrrol in 1 M Phosphorsäure wurden bessere Ergebnisse bei Verwendung von 12 g/l Poly(vinylimidazoliummethosulfat) oder 12 g/l Poly(N,N-diallyldimethylammoniumchlorid) als ohne Zusatz dieser Polymere erhalten. Gemessene Widerstandsbeiwerte: 0,8 · 10⁶ Ohm, 2 · 10⁶ Ohm, 1 · 10⁶ Ohm. Die Metallisierung erfolgte bei 3,7 A/dm².

### Beispiel 18: (Vergleich)

Nach Hydrophilisierung der Trägeroberfläche aus glasfaserverstärktem Epoxidharzmaterial (FR4-Leiterplatte) mit den bei der Leiterplattenherstellung üblichen Smear Removal-Anfangschritten: Benetzer/Queller und Chromsäurebeize wurde die Probe in einer gesättigten Eisen-III-chlorid Lösung in Propylencarbonat bei 20 - 40 °C getaucht, gespült und nach Beispiel 2 weiterbehandelt.

### Beispiel 19: (Vergleich)

Nach Beispiel 2, 14, 15 wurden als Monomerlösung 14 bis 140 g/l (0,05 - 300 g/l) Anilin in 1 N Salzsäure (Operabler pH-Bereich 0 - 2) bei vorzugsweise 12 °C (0 - 30 °C) für vorzugsweise 0,5 min (0,1-10 min) verwendet. Spülung in 1 N Salzsäure bei 25°C. Widerstandsbeiwert der trockenen Leitschichten 30 bis 90 · 10³ Ohm. Die Metallisierung erfolgte bei 0,6-10 Al_{dm}2.

### Beispiel 20: (Vergleich)

Anders als in Beispiel 19 wurde das Trägermaterial vor Verfahrensanfang mit einem organischen Lösungsmittel behandelt. Das FR4 Material wurde 1-2 min mit Essigester bei 25 °C behandelt und nach gründlicher Spülung nach Beispiel 2 weiterbehandelt. Gemessener Widerstandsbeiwert 5,5 103 Ohm.

### Beispiel 21: (Vergleich)

Analog Beispiel 19 wurde 0,05 g/l 4-Aminodiphenylamin als Monomer in 5 N Salzsäure behandelt. Die Temperatur lag bei 0 - 5 °C. Die Behandlungszeit betrug 0,5 - 5 min. Gemessene Widerstandsbeiwerte 4 - 20 · 10³ Ohm. Trockene Schichten wiesen Widerstandsbeiwerte von 0,4-2,2 · 10⁶ Ohm auf.

### Beispiele 22 und 23:

Bohrlöcher von beidseitig kaschierten Leiterplatten wurden nach den Beispielen 2 - 20 durchkontaktiert. Dazu wurde gemäß dem Verfahrensablauf des Beispiels 2 verfahren, die Leitschicht wurde mit folgenden Lösungen bei einer Temperatur von 5 °C (möglicher Bereich -10 bis +30 °C) innerhalb von 5 min gebildet:
A: 4,7 g/l Pyrrol, 127 g/l Polyethylenglykol 200 in 1 M Phosphorsäure.
B: 4,6 g/l Pyrrol in 1 M Phosphorsäure.

Die Metallisierung bei 2 Aldm² ergab nach 5 min folgende Durchlichtergebnisse in den Bohrlöchern (d0 = fehlerlos, d5 = metallfreie Stellen) :
A: d2/d2/d3
B: d5/d5/d5 (zusatzfreie Lösung)

Die Leitschicht wurde auch bei 20 °C in 5 min mit folgenden Lösungen gebildet:
A: 9 g/l Pyrrol, 26,2 g/l Polyethylenglykol 200 in 1 M Phosphorsäure,
B: 8,6 g/l Pyrrol in 1 M Phosphorsäure.

Die Metallsierung bei 2 A/dm² ergab nach 2 min folgende Durchlichtergebnisse in den Bohrlöchern:
A: d0/d0/d2
B: d2/d1/d2

Auf der Kupferoberfläche bildete sich in keinem der Fälle die schwarze Polypyrrolschicht.

### Beispiel 24: (Vergleich)

In eine gerührte Schwefelsäurelösung (pH 1,5, Temperatur: 10 °C) wurden 20 g/l Gelatine (bezogen von Fa. Fluka, Deutschland), 15,2 g/l Ammoniumperoxodisulfat und 4,5 g/l Pyrrol gegeben. Nach 1 h bei 25 °C wurde die Lösung am Ölvakuum entwässert. Ein Preßling, hergestellt mit 90 kN/cm² Preßdruck hatte einen Widerstandsbeiwert von 3 · 106 Ohm/cm.

Zum Vergleich wurde der Versuch ohne Gelatine wiederholt, wobei 28,5 g/I Ammoniumperoxodisulfat und 8,4 g/l Pyrrol eingesetzt wurden. Es wurde ein Widerstandsbeiwert von 4,1 Ohm/cm gemessen, d.h. der elektrische Widerstand des Preßlings, der ohne Zusatz von Gelatine hergestellt wurde, hatte einen um den Faktor von etwa 1000 geringeren Wert.

### Beispiel 25: (Vergleich)

Eine Lösung aus 30 g/l Gelatine mit 6,7 g/l Pyrrol ergab eine viskose Flüssigkeit. Die mit Permanganat behandelten FR4-Coupons ergaben darin keine sichtbare Polypyrrolschicht, was an der Schwarzfärbung leicht erkennbar gewesen wäre. Der Widerstandsbeiwert war größer als 30 106 Ohm.

Für die folgenden Beispiele wurden wasserlösliche Polymere beziehungsweise kationische Polyelektrolyte, Ammoniumperoxodisulfat und Pyrrol zu einer gerührten Phosphorsäurelösung, die einen pH-Wert von 1 und eine Temperatur zwischen 5 und 10 °C hatte, zugegeben. Nach 1 h wurde die Lösung filtriert und der Filterrückstand ausgiebig mit einer wäßrigen Phosphorsäurelösung (pH 1) gewaschen. Der Rückstand wurde dann im Ölvakuum getrocknet und teilweise zu einem Preßling bei 90 kN/cm² verarbeitet. Der Widerstandsbeiwert wurde am Preßling gemessen. Der getrocknete Rückstand diente zur Elementaranalyse.

### Beispiel 26: (Vergleich)

Es wurden 6,72 g/l Pyrrol und 2,28 g/l Ammoniumperoxodisulfat verwendet. Der gemessene Kohlenstoffgehalt des Rückstands betrug 40,1 Gew.-%, der gemessene Stickstoffgehalt betrug 11,2 Gew.-%. Daraus errechnet sich ein Atomverhältnis von Kohlenstoff zu Stickstoff C/N von 4,16. Der gemessene Widerstandsbeiwert betrug 2,0 Ohm/cm.

### Beispiel 27: (Vergleich)

Es wurden 7,2 g/l Pyrrol, 22,9 g/l Ammoniumperoxodisulfat und zusätzlich 11,9 g/l Polyethylenglykol 200 verwendet. Der gemessene Kohlenstoffgehalt des Rückstands betrug 31,4 Gew.-%, der gemessene Stickstoffgehalt betrug 8,8 Gew.-%. Daraus errechnet sich ein Atomverhältnis von Kohlenstoff zu Stickstoff C/N von 4,16. Der gemessene Widerstandsbeiwert betrug 1,0 Ohm/cm.

Das gemessene Atomverhältnis von Kohlenstoff zu Stickstoff C/N zeigt, daß kein Einbau des Polyethylenglykols erfolgte. Allerdings waren die elektrische Leitfähigkeit und die Metallisierung, gemessen mit dem Durchlichttest besser als ohne Zusatz (vergl. Beispiele 23 und 26).

### Beispiel 28: (Vergleich)

Es wurden 6,7 g/l Pyrrol, 22,8 g/l Ammoniumperoxodisulfat und zusätzlich 202 g/l Polyethylenglykol 200 verwendet. Der gemessene Kohlenstoffgehalt des Rückstands betrug 37,8 Gew.-%, der gemessene Stickstoffgehalt betrug 10,0 Gew.-%. Daraus errechnet sich ein Atomverhältnis von Kohlenstoff zu Stickstoff C/N von 4,40. Der gemessene Widerstandsbeiwert betrug 4,7 Ohm/cm.

Das gemessene Atomverhältnis von Kohlenstoff zu Stickstoff C/N zeigt, daß ein Einbau des Polyethylenglykols erfolgte.

### Beispiel 29: (Vergleich)

Es wurden 7,13 g/l Pyrrol, 22,8 g/l Ammoniumperoxodisulfat und zusätzlich 11,2 g/l Polyvinylpyrrolidon verwendet. Der gemessene Kohlenstoffgehalt des Rückstands betrug 32,2 Gew.-%, der gemessene Stickstoffgehalt betrug 8,5 Gew.-%. Daraus errechnet sich ein Atomverhältnis von Kohlenstoff zu Stickstoff C/N von 4,42. Der gemessene Widerstandsbeiwert betrug 2,8 Ohm/cm.

Das gemessene Atomverhältnis von Kohlenstoff zu Stickstoff C/N zeigt, daß ein Einbau des Polyvinylpyrrolidons erfolgte.

### Beispiel 30: (Vergleich)

Es wurden 7,12 g/l Pyrrol, 22,9 g/l Ammoniumperoxodisulfat und zusätzlich 11,6 g/I Polyvinylpyrrolidon verwendet. Der gemessene Kohlenstoffgehalt des Rückstands betrug 32,6 Gew.-%, der gemessene Stickstoffgehalt betrug 9,8 Gew.-%. Daraus errechnet sich ein Atomverhältnis von Kohlenstoff zu Stickstoff C/N von 3,88. Der gemessene Widerstandsbeiwert betrug 1,3 Ohm/cm.

[0091 ] Das gemessene Atomverhältnis von Kohlenstoff zu Stickstoff C/N zeigt, daß ein Einbau des Polyvinylpyrrolidons erfolgte. Die elektrische Leitfähigkeit war besser als ohne Zusatz (vergl. Beispiel 26).

### Beispiel 31: (Vergleich)

Es wurden 6,7 g/l Pyrrol, 22,8 g/l Ammoniumperoxodisulfat und zusätzlich 103 g/l Polyvinylpyrrolidon verwendet. Der gemessene Kohlenstoffgehalt des Rückstands betrug 34,3 Gew.%, der gemessene Stickstoffgehalt betrug 9,7 Gew.-%.

Daraus errechnet sich ein Atomverhältnis von Kohlenstoff zu Stickstoff C/N von 4,12. Der gemessene Widerstandsbeiwert betrug 3,8 Ohm/cm.

Auch in diesem Fall ist am gemessenen Atomverhältnis von Kohlenstoff zu Stickstoff C/N erkennbar, daß ein Einbau des Polyvinylpyrrolidons erfolgte.

### Beispiel 32: (Vergleich)

Analog zu Beispiel 2 wurde ein Kunststoff-Werkstück aus ABS-Copolymerisat mit einer alkalischen Permanganatlösung vorbehandelt und nach dem Spülen in einer Phosphorsäure-haltigen Pyrrollösung behandelt. Es bildete sich wie in Beispiel 2 ein leitfähiger schwarzer Polypyrrolfilm, der anschließend galvanisch verkupfert werden konnte.

## Patentansprüche

1. Verwendung einer Lösung, enthaltend mindestens eine durch Oxidation in ein leitfähiges Polymer überführbare aromatische Verbindung und mindestens ein wasserlösliches Polymer, ausgewählt aus der Gruppe Homopolymere und Copolymere, ausgenommen eine Lösung, enthaltend
ein Thiophen der allgemeinen Formel 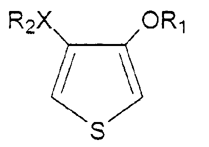 in der
X für Sauerstoff oder eine einfache Bindung,
R₁ und R₂ unabhängig voneinander für Wasserstoff oder eine Cy-C₄-Alkylgruppe stehen oder zusammen einen substituierten oder unsubstituierten C₁-C₄-Alkylen- rest oder einen Cyclohexylen1,2-Rest bilden,
und ein wasserlösliches Polymer, ausgewählt aus der Gruppe, bestehend aus polymeren organischen Säuren und Copolymeren dieser Säuren mit anderen säuregruppenfreien Monomeren,
zur Bildung der leitfähigen Polymeren auf Nichtleiteroberflächen durch Reaktion der aromatischen Verbindung mit auf den Nichtleiteroberflächen erzeugten oder adsorbierten Oxidationsmitteln.

2. Verwendung nach Anspruch 1, dadurch gekennzeichnet, daß die wasserlöslichen Polymere ausschließlich oder überwiegend ungeladene Strukturelemente enthalten und/oder kationische Polyelektrolyte sind.

3. Verwendung nach einem dervorstehenden Ansprüche, dadurch gekennzeichnet, daß die wasserlöslichen Polymere zu Protonierungs/Deprotonierungsreaktionen und/oder zur Bildung von Wasserstoffbrückenbindungen und/oder van der Waals-Wechselwirkungen befähigt sind.

4. Verwendung nach einem der vorstehenden Ansprüche, dadurch gekennzeichnet, daß die wasserlöslichen Polymere eine oder mehrere Hydroxyl-, Amid- , Sulfonamid-, Amin-, Keto-Enol-, Ether-, Keto-, Sulfoxid-, quaternäre Ammonium- und/oder Hetariniumgruppen enthalten.

5. Verwendung nach einem dervorstehenden Ansprüche, dadurch gekennzeichnet, daß die wasserlöslichen Polymere Verbindungen, ausgewählt aus der Gruppe der Polyalkylenoxide, Polyalkylenimize, Polyvinylpyridine, Polyvinylpyrrolidone, aus Epihalohydrin und Imidazolen oder Benzimidazolen hergestellten Polymere, aus mit quaternären Ammoniumgruppen derivatisierten Acrylsäure-oder Methacrylsäureverbindungen hergestellten Polymere, Poly(diallyldimethylammoniumhalogenid), quaternisierten Polypiperidiniumverbindungen, Polyaminsulfone, quaternisierten Polyvinylimidazoliumsalze, quaternisierten Polyvinylpyridiniumsalze oder lonene umfassen.

6. Verwendung nach einem der vorstehenden Ansprüche, dadurch gekennzeichnet, daß die wasserlöslichen Polymere Verbindungen, ausgewählt aus der Gruppe
Polyethylenimin,
Poly(N-methyl-ethylenimin),
Polyvinylalkohol,
Polyethylenoxid,
Polypropylenoxid,
Copolymerisat aus Polyethylenoxid und Poly propylenoxid,
Polyacrylamid,
Poly(1-vinylpyrrolidon),
Poly(2-vinylpyridin),
Poly(4-vinylpyridin),
Polyethylenglykol,
Poly(N-methyl-N-vinylimidazoliummethosulfat), Polyaminsulfone,
Poly(N,N-dimethyl-3,5-dimethylenpiperidinium- chlorid),
Poly((3-chlor-2-hydroxypropyl)-1-imidazol), Poly(N,N-diallyldimethylammoniumchlorid),
umfassen.

7. Verwendung nach einem dervorstehenden Ansprüche, dadurch gekennzeichnet, daß die wasserlöslichen Polymere in einer Konzentration zwischen 2 g/l und 250 g/l vorliegen.

8. Verwendung nach einem der vorstehenden Ansprüche, gekennzeichnet durch Pyrrol, Thiophen, Anilin, N-Phenyl-p-phenylendiamin oder deren Derivate als aromatische Verbindungen.

9. Verwendung nach einem der vorstehenden Ansprüche, gekennzeichnet durch 3- und/oder 4-mono-oder disubstituierte Pyrrolderivate als aromatische Verbindungen.

10. Verwendung nach einem der vorstehenden Ansprüche, dadurch gekennzeichnet, daß das Anilinderivat in o- und/oder m-Position und das N-Phenyl-p-phenylendiamin-Derivat symmetrisch oder unsymmetrisch in 2,2'- und/oder 5,5'- und/oder 3,3'-und/oder 6,6'-Stellung substituiert ist.

11. Verwendung nach einem der vorstehenden Ansprüche, gekennzeichnet durch in 2-,2'-Stellung verknüpfte monomere Pyrrole und bevorzugt 2,2'-Bipyrrol als Pyrrolderivat.

12. Verwendung nach einem der Ansprüche 1 - 10, gekennzeichnet durch in 2-,2'-Stellung verknüpfte monomere Thiophene und bevorzugt 2,2'-Bithiophen als Thiophenderivat.

13. Verwendung nach einem der vorstehenden Ansprüche bei der Metallisierung von Nichtleitern.

14. Verwendung nach einem der vorstehenden Ansprüche bei Verfahren zur Durchkontaktierung von Leiterplatten.

15. Verfahren zur Metallisierung von Nichtleitern mit den Verfahrensschritten:
a) Behandlung des Nichtleiters mit einer suspendierte oder gelöste Oxidationsmittel enthaltenden Lösung,
b) Behandlung mit einer Lösung, enthaltend mindestens eine aromatische Verbindung, die durch Oxidation in ein leitfähiges Polymer überführt werden kann,
dadurch gekennzeichnet, daß die Lösung in Schritt b) zusätzlich mindestens ein wasserlösliches Polymer, ausgewählt aus der Gruppe Homopolymere und Copolymere, enthält,
wobei eine Behandlung in Schritt b) mit einer Lösung ausgenommen ist, die
ein Thiophen der allgemeinen Formel 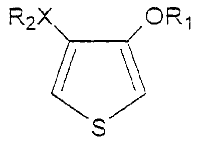 in der
X für Sauerstoff oder eine einfache Bindung,
R₁ und R₂ unabhängig voneinander für Wasserstoff oder eine Cᵢ-C₄-Alkylgruppe stehen oder zusammen einen substituierten oder unsubstituierten C₁-C₄-Alkylen- rest oder einen Cyclohexylen-1,2-Rest bilden,
und ein wasserlösliches Polymer, ausgewählt aus der Gruppe, bestehend aus polymeren organischen Säuren und Copolymeren dieser Säuren mit anderen säuregruppenfreien Monomeren, enthält.

16. Verfahren nach Anspruch 15, dadurch gekennzeichnet, daß die lösung in Schritt b) auf einen pH-Wert von 0 bis 4 eingestellt ist.

17. Verfahren nach einem der Ansprüche 15 oder 16, gekennzeichnet durch eine Lösung gemäß Schritt b) mit einem oder mehreren der Merkmale nach den Ansprüchen 2 bis 12.

18. Verfahren nach einem der Ansprüche 15 - 17, gekennzeichnet durch Permanganat und/oder Manganat und/oder Braunstein als Oxidationsmittel.

19. Verfahren nach einem der Ansprüche 15 - 18, gekennzeichnet durch eine Permanganat und Alkalihydroxid enthaltende Lösung in Schritt b).

20. Verfahren nach einem der Ansprüche 15 - 19, dadurch gekennzeichnet, daß Manganat bei 80 bis 100 °C in Gegenwart von Hydroxid und Permanganat erzeugt wird.

21. Verfahren nach einem der Ansprüche 15 - 17, gekennzeichnet durch eine Eisen-III-chlorid, ein organisches Lösungsmittel und/oder Wasser enthaltende Lösung in Schritt b).

22. Verfahren nach einem der Ansprüche 15 - 21, dadurch gekennzeichnet, daß die Lösung in Schritt b) auf eine Temperatur von -10 °C bis +30 °C eingestellt ist.

23. Verfahren nach einem der Ansprüche 15 - 22, ausgeführt in einer horizontalen Behandlungsanlage.

24. Verfahren nach einem der Ansprüche 15-23, dadurch gekennzeichnet, daß der nach Verfahrensschrift b) behandelte Nichtleiter galvanisch metallisiert wird.

## Claims

1. Use of a solution containing at least one aromatic compound, which is convertible into a conductive polymer by oxidation, and at least one water-soluble polymer, selected from the group of homopolymers and copolymers, excluding a solution containing
a thiophene of the general formula 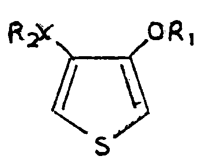 in which
X stands for oxygen or a single bond,
R₁ and R₂ stand independently of each other for hydrogen or a Cᵢ-C₄ alkyl group or together form a substituted or unsubstituted C₁-C₄ alkylene radical or a cyclohexylene 1,2-radical,
and a water-soluble polymer, selected from the group comprising polymeric organic acids and copolymers of these acids with other monomers, which are free of acid groups,
to form the conductive polymers on non-conductor surfaces by reacting the aromatic compound with oxidising agents, which are produced or adsorbed on non-conductor surfaces.

2. Use according to claim 1, characterised in that the water-soluble polymers exclusively or predominantly contain uncharged structural elements and/or are cationic polyelectrolytes.

3. Use according to one of the preceding claims, characterised in that the water-soluble polymers are capable of protonation/deprotonation reactions and/or forming hydrogen bridging bonds and/or van der Waals mutual reactions.

4. Use according to one of the preceding claims, characterised in that the water-soluble polymers contain one or more hydroxyl, amide, sulphonamide, amine, keto-enol, ether, keto, sulphoxide, quaternary ammonium and/or hetarinium groups.

5. Use according to one of the preceding claims, characterised in that the water-soluble polymers include compounds selected from the group of polyalkylene oxides, polyalkylene imines, polyvinyl pyridines, polyvinyl pyrrol-idones, polymers produced from epihalohydrine and imidazoles or benzimidazoles, polymers produced from acrylic acid or methacrylic acid compounds and with the quaternary ammonium derivatives, poly(diallyldimethyl ammonium halide), quaternised polypiperidinium compounds, polyamine sulphones, quaternised polyvinyl imidazolium salts, quaternised polyvinyl pyridinium salts or ionenes.

6. Use according to one of the preceding claims, characterised in that the water-soluble polymers include compounds selected from the group
polyethylene imine
poly(N-methyl-ethylene imine),
polyvinyl alcohol,
polyethylene oxide,
polypropylene oxide,
copolymer from polyethylene oxide and polypropylene oxide,
polyacrylamide,
poly(1-vinylpyrrol-idone),
poly(2-vinylpyridine),
po!y(4-viny!pyr!d!ne),
polyethylene glycol,
poly(N-methyl-N-vinylimidazolium methosul- phate),
polyamine sulphones,
poly(N,N-dimethyl-3,5-dimethylene piperidinium chloride),
poly(3-chloro-2-hydroxypropyl)-1-imidazole), poly(N,N-diallyldimethyl ammonium chloride).

7. Use according to one of the preceding claims, characterised in that the water-soluble polymers are in a concentration of between 2 g/I and 250 g/I.

8. Use according to one of the preceding claims, characterised by pyrrole, thiophene, aniline, N-phenyl-p-phenylene-diamine or their derivatives as aromatic compounds.

9. Use according to one of the preceding claims, characterised by 3- and/or 4-mono- or disubstituted pyrrole derivatives as aromatic compounds.

10. Use according to one of the preceding claims, characterised in that the aniline derivative in o- and/or m-position and the N-phenyl-p-phenylene diamine derivative is substituted symmetrically or unsymmetrically in 2,2'- and/or 5,5' and/or 3,3'- and/or 6,6'-position.

11. Use according to one of the preceding claims, characterised by monomeric pyrroles, which are linked in 2-,2'-position, and preferably 2,2' bipyrrole as a pyrrole derivative.

12. Use according to one of claims 1 - 10, characterised by monomeric thiophenes, which are linked in 2-,2'-position, and preferably 2,2' bithiophene as a thiophene derivative.

13. Use, according to one of the preceding claims, in the metallisation of non-conductors.

14. Use, according to one of the preceding claims, in methods for throughplating printed circuit boards.

15. Method of metallising non-conductors, having the following method steps:
a) treatment of the non-conductors with a solution containing suspended or dissolved oxidising agents,
b) treatment with a solution, containing at least one aromatic compound which can be converted into a conductive polymer by oxidation,
characterised in that the solution in step b) additionally contains at least one water-soluble polymer, selected from the group of homopolymers and copolymers,
a treatment in step b) being excluded with a solution containing
a thiophene of the general formula 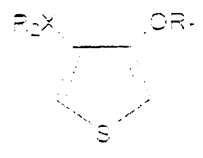 in which
X stands for oxygen or a single bond,
R₁ and R₂ stand independently of each other for hydrogen or a C₁-C₄ alkyl group or together form a substituted or unsubstituted Cᵢ-C₄ alkylene radical or a cyclohexylene 1,2-radical,
and a water-soluble polymer, selected from the group comprising polymeric organic acids and copolymers of these acids with other monomers, which are free of acid groups.

16. Method according to claim 15, characterised in that the solution in step b) is set to a pH value of between 0 and 4.

17. Method according to one of claims 15 or 16, characterised by a solution according to step b) having one or more of the features according to claims 2 to 12.

18. Method according to one of claims 15 - 17, characterised by permanganate and/or manganate and/or manganese dioxide as the oxidising agent.

19. Method according to one of claims 15 - 18, characterised by a solution in step b) containing permanganate and alkali hydroxide.

20. Method according to one of claims 15 - 19, characterised in that manganate is produced at between 80 and 100° C in the presence of hydroxide and permanganate.

21. Method according to one of claims 15 - 17, characterised by a solution in step b) containing iron-III- chloride, an organic solvent and/or water.

22. Method according to one of claims 15 - 21, characterised in that the solution in step b) is set to a temperature of from -10° C to +30° C.

23. Method according to one of claims 15 - 22, accomplished in a horizontal treatment plant.

24. Method according to one of claims 15 - 23, characterised in that the non-conductor, treated according to method step b), is galvanically plated.

## Revendications

1. Utilisation d'une solution contenant au moins un composé aromatique pouvant être transformé par oxydation en un polymère conducteur et au moins un polymère soluble dans l'eau choisi dans le groupe des homopolymères et des copolymères, à l'exception d'une solution contenant
un thiophène de la formule générale 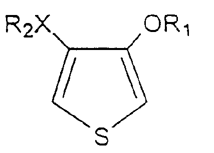 dans laquelle
X représente un oxygène ou une liaison simple,
R₁ et R₂ représentent indépendamment l'un vers l'autre un hydrogène ou un groupe alkyle en C₁ à C₄, ou bien forment ensemble un résidu aklylène en Ci à C₄ substitué ou non substitué ou un résidu 1,2-cyclohexylène,
et un polymère soluble dans l'eau, choisi dans le groupe comprenant des acides organiques polymères et des copolymères de ces acides avec d'autres monomères exempts de groupes acides,
pour la formation des polymères conducteurs sur des surfaces non conductrices par réaction du composé aromatique avec des agents oxydants créés ou adsorbés sur les surfaces non conductrices.

2. Utilisation selon la revendication 1, caractérisée en ce que les polymères solubles dans l'eau contiennent exclusivement ou principalement des éléments structurels non chargés et/ ou sont des polyélectrolytes cationiques.

3. Utilisation selon l'une des revendications précédentes, caractérisée en ce que les polymères solubles dans l'eau sont rendus capables de réactions de protonation/ déprotonation et/ ou capables de former des liaisons hydrogène et/ou de van der Waals.

4. Utilisation selon l'une des revendications précédentes, caractérisée en ce que les polymères solubles dans l'eau contiennent un ou plusieurs groupes hydroxyle, amide, sulfamide, amine, céto-énole, éther, cétone, oxosulfoxyde, ammonium et/ ou hétarinium quaternaire.

5. Utilisation selon l'une des revendications précédentes, caractérisée en ce que les polymères solubles dans l'eau contiennent des composés choisis parmi le groupe des oxydes de polyalkylène, des polyalkylène-imines, des polyvinylpyridines, des polyvinyl- pyrrolidones, des polymères obtenus à partir d'épihalohydrine et dimidazoles ou de benzimidazoles, des polymères obtenus à partir de composés d'acide acrylique ou d'acide méthacrylique dérivés par des groupes d'ammonium quaternaire, de l'halogénure de poly(diallyldiméthylammonium), des composés de polypipéridinium quaternaires, des polyaminesulfones, des sels de polyvinylimida- zolium quaternaires, des sels de polyvinylpyridi- nium quaternaires ou des ionènes.

6. Utilisation selon l'une des revendications précédentes, caractérisée en ce que les polymères solubles dans l'eau contiennent des composés choisis parmi le groupe
polyéthylène-imine,
poly(N-méthyl-éthylène-imine),
polyvinyl-alcool,
oxyde de polyéthylène,
oxyde de polypropylène,
copolymérisat d'oxyde de polyéthylène et d'oxyde de polypropylène,
polyacrylo-amide,
poly(1-vinylpyrrolidone),
poly(2-vinylpyridine),
poly(4-vinylpyridine),
polyéthylèneglycol
méthosulfate de poly(N-méthyl-N-vinylimidazo- lium),
polyaminosulfones,
chlorure de poly(N,N-diméthyl-3,5-diméthylè- nepipéridinium),
poly((3-chlore-2-hydroxypropyl)-1-imidazole), chlorure de poly(N,N-diallyldiméthylammo- nium).

7. Utilisation selon l'une des revendications précédentes, caractérisée en ce que les polymères solubles dans l'eau sont présents à une concentration comprise entre 2 g/l et 250 g/I.

8. Utilisation selon l'une des revendications précédentes, caractérisée par du pyrrole, du thiophène, de l'aniline, de la N-phényl-p-phénylènediamine ou leur dérivés à titre de composés aromatiques.

9. Utilisation selon l'une des revendications précédentes, caractérisée par des dérivés de pyrrole 3- et/ou 4- mono ou disubstitués à titre de composés aromatiques.

10. Utilisation selon l'une des revendications précédentes, caractérisée en ce que le dérivé de l'aniline est substitué en position o et/ou m et le dérivé du N-phényl-p-phénylènediamine est substitué symétriquement ou asymétriquement en position 2,2' et/ou 5,5' et/ou 3,3' et/ou 6,6'.

11. Utilisation selon l'une des revendications précédentes, caractérisée par des pyrroles monomériques reliés en position 2,2' et de préférence par du 2,2'- bipyrrole à titre de dérivé de pyrrole.

12. Utilisation selon l'une des revendications 1 à 10, caractérisé par des thiophènes monomériques reliés en position 2,2' et de préférence par du 2,2'- bithiophène à titre de dérivés de thiophène.

13. Utilisation selon l'une des revendications précédentes lors de la métallisation de non conducteurs.

14. Utilisation selon l'une des revendications précédentes lors de procédés permettant la réalisation des connexions sur des cartes à circuits imprimés.

15. Procédé de métallisation de non conducteurs comportant les étapes de procédé suivantes :
a) traitement du non conducteur avec une solution contenant des agents oxydants en suspension ou dissous,
b) traitement avec une solution, contenant au moins un composé aromatique qui peut être transformé par oxydation en polymère conducteur,
caractérisé en ce que la solution de l'étape b) confient en outre au moins un polymère soluble dans l'eau choisi dans le groupe des homopolymères et copolymères,
dans lequel est exclu à l'étape b) un traitement avec une solution contenant
un thiophène de la formule générale 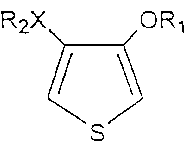 dans laquelle
X représente un oxygène ou une liaison simple,
R₁ et R₂ représentent indépendamment l'un vers l'autre un hydrogène ou un groupe alkyle en C₁ à C₄, ou bien forment ensemble un résidu aklylène en C₁ à C₄ substitué ou non substitué ou un résidu 1,2-cyclohex^{y}lène,
et un polymère soluble dans l'eau choisi dans le groupe comprenant des acides organiques polymères et des copolymères de ces acides avec d'autres monomères exempts de groupes acides.

16. Procédé selon la revendication 15, caractérisé en ce que la solution de l'étape b) est définie avec un pH de 0 à 4.

17. Procédé selon l'une des revendications 15 ou 16, caractérisé par une solution selon l'étape b) présentant une ou plusieurs des caractéristiques selon les revendications 2 à 12.

18. Procédé selon l'une des revendications 15 à 17, caractérisé par du permanganate et/ ou du manganate et/ ou du bioxyde de manganèse, à titre d'agent oxydant.

19. Procédé selon l'une des revendications 15 à 18, caractérisé par une solution de l'étape b) contenant du permanganate et de l'hydroxyde alcalin.

20. Procédé selon l'une des revendications 15 à 19, caractérisé en ce que le manganate est généré à une température de 80 à 100°C en présence d'hydroxyde et de permanganate.

21. Procédé selon l'une des revendications 15 à 17, caractérisé par une solution de l'étape b) contenant du chlorure ferrique, un solvant organique et/ou de l'eau.

22. Procédé selon l'une des revendications 15 à 21, caractérisé en ce que la solution de l'étape b) est réglée sur une température de -10°C à +30°C.

23. Procédé selon l'une des revendications 15 à 22, mis en oeuvre dans une installation de traitement horizontale.

24. Procédé selon l'une des revendications 15 à 23 caractérisé en ce que le non conducteur traité selon l'étape de procédé b) est métallisé par galvanisation.
